# EUROPEAN PATENT APPLICATION

(11) **EP 1 945 013 A1**
(43) Date of publication of application: **16.07.2008**
(21) Application number: 06822015.1
(22) Date of filing: 16.10.2006
(51) Int. Cl.: H05K 3/46, H01L 23/12

(54) **MULTILAYER PRINTED WIRING BOARD AND METHOD FOR MANUFACTURING SAME**

(30) Priority: 14.10.2005 JP 2005300349
(71) Applicant: IBIDEN CO., LTD., Ogaki-shi Gifu 503-8604 (JP)
(72) Inventor: ITO, Sotaro, Ogaki-shi, Gifu 503-0961 (JP); TAKAHASHI, Michimasa, Ogaki-shi, Gifu 503-0961 (JP); MIKADO, Yukinobu, Ogaki-shi, Gifu 503-0961 (JP)
(74) Representative: HOFFMANN EITLE
(86) International application number: PCT/JP2006/320988
(87) International publication number: WO 2007/043714

(57) **Abstract**

A multilayer printed circuit board or a substrate on which a semiconductor element is mounted, wherein, on a resin-insulating layer that houses the semiconductor element, another resin-insulating layer and a conductor circuit have been formed sequentially with an electrical connection through a via hole between said semiconductor element and conductor circuit, wherein said semiconductor element is housed in a concave portion provided on the resin-insulating layer, and a metal layer, on which said semiconductor element is placed, is formed on the bottom of the concave portion; or a substrate on which the semiconductor element is mounted. As a result, a multilayer printed circuit board can be obtained on which an embedded semiconductor element is electrically connected through a via hole.

## Description

### Technical Field

The present invention relates to a multilayer printed circuit board, in which electronic components (semiconductor elements) such as IC are embedded and, more specifically, to a multilayer printed circuit board and the manufacturing method thereof in which the electronic connectivity or connection reliability is not easily lowered between a pad of semiconductor elements and a conductor circuit of a multilayer printed circuit board.

### Background Art

Multilayer printed circuit boards embedding semiconductor elements exist and are disclosed in, for example, Unexamined Patent Application Publication No. 2001-339165 or Unexamined Patent Application Publication No. 2002-050874. The multilayer printed circuit boards which are disclosed in these documents are comprising substrates on which a concave portion for embedding semiconductor elements is formed, semiconductor elements embedded in the concave portion of the substrate, an insulating layer formed on the substrate in order to coat the semiconductor elements, a conductor circuit formed on the surface of the insulating layer, and a via hole provided in the insulating layer to electrically connect the conductor circuit to a pad of the semiconductor elements.

Such typical multilayer printed circuit boards comprise an external connecting terminal (for example, PGA, BGA and the like) on the surface of the outermost layer, and semiconductor elements embedded in a substrate so as to be connected electrically to the outside through these external connecting terminals.

However, in the prior art as described above, there has been a problem in the electrical connectivity or connection reliability between the pad of the semiconductor element embedded in the substrate and the conductor circuit. In particular, a poor connection can easily occur near the pad of the semiconductor element or a via hole connected to the pad. Specifically, a resin substrate, in which a concave portion that houses semiconductor elements is formed, is mainly formed by resin material made by immersing a reinforcing material such as glass fabric in epoxy resin or the like; therefore, depending on the position, irregular concavity and convexity are formed on the bottom of the concave portion formed using a spot-facing process, and thereby the depth of the concave portion can easily become nonuniform. In particular, at the approximate four corners of a concave portion in which the cross-section is formed to be rectangular, the depth of the concave portion tends to be shallow compared to other parts. As a result, when the semiconductor element is housed in the concave portion, the entirety of the semiconductor element may not be sufficiently retained in a horizontal position, being held somewhat at an angle. In such a state, the pad of the semiconductor element is also somewhat at an angle, so the via hole connecting the pad and the conductor circuit cannot be easily formed in a desired shape, thereby easily causing a poor connection. As a result, electrical connectivity and connection reliability may drop.

Moreover, when adhering and fixing a semiconductor element to the bottom of the concave portion by providing an adhesive layer between the semiconductor element and the bottom of the concave portion, adhesiveness of the semiconductor element to the concave portion can easily become nonuniform, because the surface condition of the bottom of the concave portion is nonuniform, and the adhesive layer may not easily be uniformly extended. Therefore, adhesive strength of the semiconductor element may not be easily obtained.

When conducting a reliability test under a heat cycle condition, adhesiveness of the semiconductor element to the concave portion may significantly decrease.

The purpose of the present invention is to solve the above problems existing in the conventional art, and to provide a multilayer printed wiring board and a method for manufacturing the same capable of securing electrical connectivity and connection reliability even when the substrate housing the semiconductor element is made of resin, and in particular, capable of preventing the connection reliability from being easily lowered between the pad of the semiconductor element and a conductor circuit, including a via hole connected thereto in reliability tests.

### Summary of the Invention

As a result of keen examination for achieving the above purpose, the present inventors have found that, if the depth of the concave portion for housing the semiconductor element providing the resin substrate is not uniform to some extent, electrical connectivity and connection reliability tend to drop between the pad of the semiconductor element embedded in the substrate and the conductor circuit connected thereto, and devised the present invention that has the following main components based on such findings.

Specifically, the present invention comprises:
(1) a multilayer printed circuit board, wherein, on a resin-insulating layer that houses a semiconductor element, another resin-insulating layer and conductor circuit have been formed with electrical connection through a via hole between said semiconductor element and conductor circuit,
wherein said semiconductor element is housed in a concave portion provided on the resin-insulating layer, and a metal layer, on which said semiconductor element is placed, is formed on the bottom of the concave portion.

Moreover, the present invention comprises:
(2) a multilayer printed circuit board, wherein, on a resin-insulating layer that houses a semiconductor element, another resin-insulating layer and conductor circuit have been formed with electrical connection through a via hole between said semiconductor element and conductor circuit,
wherein said semiconductor element is housed in a concave portion provided on the resin-insulating layer, and a metal layer, on which said semiconductor element is placed, is formed on the bottom of the concave portion, and said another resin-insulating layer has a fiber base material.

For the inventions described in (1) and (2) above, it is preferable for a conductor circuit to have been formed on a resin-insulating layer that houses the semiconductor element, said conductor circuit being electrically connected with a conductor circuit formed on another resin-insulating layer through a via hole.

Moreover, it is preferable for a conductor circuit to have been formed on a resin-insulating layer that houses the semiconductor element, said conductor circuit being electrically connected with a conductor circuit formed on another resin-insulating layer through a metal-filled via hole.

It is also preferable for the thickness of the resin-insulating layer that houses the semiconductor element to be greater than the thickness of another resin-insulating layer. As a result, warping due to the heat of the resin-insulating layer that houses the semiconductor element will not easily. This makes it easier to ensure connectivity and reliability between the semiconductor element and the via hole connected thereto.

In addition, it is also possible for the conductor circuit on said other resin-insulating layer to extend beyond the border between the semiconductor element and the resin-insulating layer that houses said semiconductor element. As a result, the degree of freedom of wiring for the conductor circuit connected to the semiconductor element will increase. Moreover, a solder pad that is externally connected and the via hole connected to the semiconductor are separated from each other, so it is assumed that the effect of stress such as heat induced externally on the solder pad will not easily be transferred, thus ensuring connectivity and reliability.

Furthermore, in embodiments of the present invention, a structure is also possible in which a via hole connected to a metal layer is formed to release the heat generated in the semiconductor element through this via hole. In other words, a thermal via hole connected to a metal layer can also be formed, thereby releasing the heat of the semiconductor element due to the metal layer outside.

Moreover, the present invention comprises:
(3) a multilayer printed circuit board, wherein, on a resin-insulating layer that houses a semiconductor element, another resin-insulating layer and conductor circuit have been formed with electrical connection through a via hole between said semiconductor element and conductor circuit,
wherein said semiconductor element is housed in a concave portion provided on the resin-insulating layer, and a metal layer, on which said semiconductor element is placed, is formed on the bottom of the concave portion, and said metal layer is formed on an area that is greater than the area of the bottom of the concave portion.

With such a configuration, it becomes easier to ensure the capacity to house the semiconductor element. Moreover, displacement of alignment when forming the concave portion on the substrate is allowed. Therefore, the depth of the concave portion provided in the resin-insulating layer can be easily made uniform, and it is not easily affected by other factors (e.g., the effect of concavity and convexity when forming the convex portion or an effect when forming the metal layer is not caused).

In the present invention, it is preferable for the surface of said metal layer to be planarized. This is because the uniform thickness of the adhesive layer formed between the semiconductor element and the metal layer can easily be achieved, and adhesiveness of the semiconductor element becomes uniform, and further, it becomes easier to ensure adhesiveness even when reliability tests are repeatedly performed under a heat cycle condition.

Moreover, said bottom metal layer should preferably be formed from rolled copper foil. It becomes easier to ensure flatness of the metal layer when it is formed from rolled copper foil. In addition, the capacity to house the semiconductor element and adhesiveness of the semiconductor element can also be ensured more easily.

Furthermore, it is preferable that the wall surface of the concave portion of said resin-insulating layer will be exposed. In other words, the wall surface of the concave portion will be exposed when the semiconductor element is housed. Therefore, the capacity to house the semiconductor element is ensured. In addition, an adhesive or another resin-insulating layer can be filled onto the wall surface of the concave portion, and thus, the bonding property of the semiconductor element and electrical connectivity of the semiconductor element can more easily be ensured.

Moreover, it is preferable for said metal layer to be exposed by laser processing. This makes the depth of the concave portion uniform.

Furthermore, the thickness of the metal layer exposed in said concave portion should preferably be less than the thickness of the unexposed portion. This forms a recess in the area where the semiconductor element is housed, so it is assumed that the capacity to house the semiconductor will be ensured more easily.

Additionally, the surface of the metal layer exposed in said concave portion should preferably be a shiny surface. This is because adhesiveness between the metal layer and the semiconductor element is more easily ensured by a shiny surface, and also, connectivity and reliability of the semiconductor element is more easily ensured. Moreover, the uniform thickness of the adhesive layer formed between the semiconductor element and the metal layer can be easily achieved, and adhesiveness of the semiconductor element becomes uniform, and further, it becomes easier to ensure adhesiveness, even when reliability tests are repeatedly performed under a heat cycle condition.

In addition, the surface opposite to the exposed surface of said metal layer in said concave portion should preferably be a matte surface. This is because adhesiveness to another resin-insulating layer is ensured.

Furthermore, the semiconductor element is preferably joined to said metal layer by an adhesive layer. The adhesive layer is formed on the metal layer, so the adhesive layer easily becomes uniform, and the bonding property of the semiconductor element can be ensured more easily. In addition, connectivity and reliability between the semiconductor element and the via hole connected thereto is more easily ensured.

Furthermore, it is preferable that the adhesive layer touches the bottom periphery of the bottom and side of the semiconductor elements. Touching the adhesive layer to the bottom periphery of the bottom and side of the semiconductor elements ensures adhesiveness of semiconductor elements.

Moreover, said metal layer should preferably be embedded in advance within the substrate that houses the semiconductor element. By being embedded within the substrate, flatness of the metal layer is not often degraded due to other factors. Therefore, adhesiveness to the semiconductor elements is more easily ensured.

In addition, it is preferable for the applicable metal layer to be embedded in advance within the substrate or to be nearly flat. Therefore, the depth of the concave portion provided in the resin-insulating layer can be easily made uniform, and it is not easily affected by other factors (e.g., the effect of concavity and convexity when forming the convex portion or an effect when forming the metal layer is not caused).

Thus, the semiconductor element is prevented from being tilted when housing the semiconductor element within the concave portion, so the via hole can take a desired shape when forming the via hole connected to the pad of the housed semiconductor element on the resin-insulating layer. A nearly flat metal layer leads to a nearly flat electrode pad placed on the surface of the semiconductor element, so connectivity of the via hole is more easily ensured.

Forming the side of the concave portion for housing said semiconductor element in a tapered shape enables the reduction of stress on semiconductor elements that are housed in the concave portions, even when stress is applied toward the side (e.g., thermal stress and external stress).

Also, regarding the adhesive for fixing the semiconductor element, the adhesive does not spread along the side of the concave portion, reducing degradation of adhesiveness of the semiconductor element to the bottom of the concave portion.

In addition, in the present invention, a columnar electrode or a mediation layer can be formed on the pad of the semiconductor element. This makes it easy to electrically connect the pad of semiconductor element and a via hole.

A pad of semiconductor elements is generally manufactured from aluminum or the like, but when a via hole is formed in the inter-layer insulating layer by photo-etching using a pad made from aluminum on which a mediation layer is not formed, resin can easily be left on the surface of the pad after exposure and developing, and in addition, tarnishing of the pad may be caused by applying a developing solution.

On the other hand, when via holes are formed using a laser, there is a risk of burning out the aluminum pads. Also, when laser radiation is applied under conditions so as to avoid burning out, resin may be left on the pad. Moreover, tarnishing and dissolution of the pad of semiconductor elements sometimes occurs via post-processing (e.g., immersion processing in acid, oxidizer or etching solution, various anneal processes and so on). Furthermore, pads of semiconductor elements are made to be about 40 µm in diameter and the via hole is made to have a larger diameter, making it easy differences in position to occur and causing defects such as disconnection between the pad and the via hole.

On the other hand, providing a mediation layer made from copper and the like on the pad of the semiconductor elements resolves problems due to forming via holes and creates solutions, thus preventing resin from being left on the pad and also preventing the pad from tarnishing and dissolving through post-processing. This makes it difficult for electronic connectivity and connection reliability between the pad and the via hole to drop. Furthermore, providing a mediation layer with a larger diameter than the die pad of the semiconductor elements enables the pad and via hole to connect without fail.

Furthermore, providing a mediation layer makes it easy to carry out operation checks and electric testing on semiconductor elements before or after semiconductor elements are embedded or housed in a printed circuit board. This is because a larger mediation layer than the pad of semiconductor elements is provided, and thus probe pins for testing can easily come in contact. Therefore, it is possible to evaluate good and bad products in advance and improve productivity and costs. Additionally, it makes it difficult for pad damage or scratches caused by the probe to occur. Thus, the formation of a mediation layer on the pad of semiconductor elements allows semiconductor elements to be properly embedded and housed in a printed circuit board.

Moreover, the present invention comprises:
(4) a multilayer printed circuit board, wherein, on a resin-insulating layer that houses a semiconductor element, another resin-insulating layer and conductor circuit have been formed with electrical connection through a via hole between said semiconductor element and conductor circuit,
wherein said semiconductor element is housed in a concave portion provided on the resin-insulating layer, and a metal layer, on which said semiconductor element is placed, is formed on the bottom of the concave portion, and the wall surface of said concave portion is exposed.

Furthermore, in the present invention, it is preferable that the space between the wall surface of the concave portion and the side of semiconductor elements is filled with a resin layer. Filling with resin can ensure connectivity and reliability of semiconductor elements in order to stabilize the semiconductor elements.

Furthermore, it is preferable for the space between the wall surface of the concave portion and the side of semiconductor elements to be filled with a resin layer, and the resin-insulating layer to be integrated into one unit. Thus, the resin-insulating layer in which a via hole is formed and the resin-insulating layer filling the space between the wall surface of the concave portion and the side of the semiconductor elements are of the same material, so thermal stress caused by the difference in coefficient of thermal expansion between materials is reduced, and the semiconductor element becomes more stable, thereby easily ensuring connectivity and reliability of the semiconductor element.

In addition, the concave portion provided on the substrate may be formed such that it has a tapered side so as to become broader from the bottom upward.

Furthermore, a columnar electrode or a mediation layer may be formed on a pad of the semiconductor element, and the pad and the via hole may be electrically connected through the columnar electrode or the mediation layer.

Moreover, the present invention comprises:
(5) a multilayer printed circuit board, wherein, on a resin-insulating layer that houses a semiconductor element, another resin-insulating layer and conductor circuit have been formed with electrical connection through a via hole between said semiconductor element and conductor circuit,
wherein said semiconductor element is housed in a concave portion provided on the resin-insulating layer, and a metal layer, on which said semiconductor element is placed, is formed on the bottom of the concave portion, and an opening that forms said via hole is filled with a conductive material.

In the present invention, the via hole is a so-called filled via hole, so electrical properties via connection to the semiconductor element can more easily become stable. Therefore, connectivity is expected to become stable. In addition, when an insulating layer or conductor layer is provided over the via hole, flexure is not easily caused and electrical connectivity is more easily ensured. Additionally, plating, conductive paste, and the like can be used as a conductive material.

Moreover, it is preferable for a cross-section of the via hole to have a drum shape, i.e., inwardly-recessed shape in the thickness direction. As a result, the resin-insulating layer is fitted into the via hole, so it is assumed that the bonding property of the via hole can be easily obtained.

In addition, it is preferable for a solder pad to be placed above said semiconductor element. It is easy to maintain the distance from the semiconductor element to a minimum and to obtain electrical properties.

Furthermore, it is preferable for one or more layers of resin-insulating layer to be laminated on said other resin-insulating layer, and a via hole that is to be connected to the conductor circuit to be formed. Consequently, further wiring is possible. It is also assumed that connectivity and reliability can be easily obtained, such as being able to be externally connected to semiconductor elements or able to shift the position.

Furthermore, it is preferable for a columnar electrode or a mediation layer to be formed on a pad of the semiconductor elements, and the pad and the via hole to be electrically connected through the columnar electrode or the mediation layer.

Moreover, the present invention comprises:
(6) a multilayer printed circuit board, wherein, on a resin-insulating layer that houses a semiconductor element, another resin-insulating layer and conductor circuit have been formed with electrical connection through a via hole between said semiconductor element and conductor circuit,
wherein the sidewall of said concave portion has a tapered shape so as to become broader from the bottom upward.

In the present invention, the tapered shape of the concave portion should preferably have a smaller angle between the side and bottom of at least 60 degrees but less than 90 degrees. This is because stress at the side of the semiconductor element can be reduced, and displacement of the semiconductor element can be suppressed.

Furthermore, it is preferable for the wall surface of the concave portion to be exposed. This is because the shape of the concave portion becomes stable, and the capacity to house the semiconductor element can be ensured.

Furthermore, it is preferable that the space between the wall surface of said concave portion and the side of semiconductor elements is filled with a resin layer. This is because filling with resin can ensure connectivity and reliability of semiconductor elements due to stabilization of the semiconductor elements.

In addition, it is preferable for the space between the wall surface of the concave portion and the side of semiconductor elements to be filled with a resin layer, and the resin-insulating layer to be integrated into one unit. Thus, the resin-insulating layer in which a via hole is formed and the resin-insulating layer filling the space between the wall surface of the concave portion and the side of the semiconductor elements will be composed of the same material, so thermal stress caused by a difference in the coefficient of thermal expansion between materials is reduced, and the semiconductor element becomes stable, and thereby, connectivity and reliability of the semiconductor element can be easily ensured.

Furthermore, the present invention comprises:
(7) a method of manufacturing a multilayer printed circuit board, wherein, on a resin-insulating layer on which a semiconductor element is housed and fixed, another resin-insulating layer and a conductor circuit are formed sequentially with electrical connection though a via hole between said semiconductor element and conductor circuit, said method at least comprising the steps of:
(a) forming a first insulating resin base material, by forming, on one surface of the resin-insulating layer, at least a conductor circuit and a metal layer with a predetermined area related to the size of the semiconductor element to be housed, and forming, on the other surface of the resin-insulating layer, at least a conductor circuit and a conductor circuit non-formation area facing said metal layer with a predetermined area related to the size of the semiconductor element, and then forming a via hole for electrically connecting the conductor circuit on one surface and the conductor circuit on the other surface;
(b) unifying by crimping a second insulating resin base material on which a copper foil is attached on one surface of the resin-insulating layer with said one surface of said first insulating resin base material;
(c) forming a conductor circuit on one surface of said second insulating resin base material and forming a via hole to electrically connect said conductor circuit to the conductor circuit formed on said one surface of said first insulating resin base material;
(d) forming, on the conductor circuit non-formation area of said first insulating resin base material, a concave portion extending from a resin-insulating layer surface to the metal layer to expose the surface of the metal layer,
(e) housing a semiconductor element within said concave portion and adhering and fixing it on the surface of the metal layer exposed within said concave portion using an adhesive; and
(f) coating said semiconductor element and forming another resin-insulating layer and a conductor circuit sequentially, and then forming a via hole to electrically connect on one surface of said second insulating resin base material and forming a via hole to electrically connect said semiconductor element and said conductor circuit.

In the manufacturing method in accordance with the present invention, said concave portion should preferably be formed by laser radiation.

Moreover, it is preferable for said concave portion to have a tapered side so as to become broader from the bottom upward.

In addition, if a columnar electrode or a mediation layer is formed in advance on a pad of the semiconductor element, the pad and the via hole can be electrically connected through the columnar electrode or the mediation layer.

Furthermore, according to the manufacturing method of the present invention, it is easy to obtain a uniform depth of the concave portion by forming a metal layer on the bottom of the concave portion provided on the resin-insulating layer. In particular, if the cross-section of the concave portion is rectangular, it is easy to equalize the depth of the concave portion around the four corners.

In addition, it is preferable for the applicable metal layer to be embedded in advance and to be nearly flat. Therefore, the depth of the concave portion provided in the resin-insulating layer can more easily be made uniform, and it is not easily affected by other factors (e.g., the effect of concavity and convexity when forming the convex portion or an effect when forming the metal layer is not caused).

Furthermore, a metal layer is formed within a resin insulating layer, and thus, the influence of thermal stress and external stress do not often cause warping. As a result, for example, a poor connection cannot be easily occur between the connection pad of semiconductor elements and a conductor circuit, such as via holes, and therefore, the electronic connectivity and connection reliability can be easily ensured.

In addition, said metal layer will be nearly flat, so the electrical connectivity and connection reliability can be more easily ensured.

### Brief Description of the Drawings

Fig. 1 is a schematic sectional drawing describing a multilayer printed wiring board in which the semiconductor according to the present invention is housed or embedded;
Fig. 2 is a schematic sectional drawing describing a multilayer printed circuit board having a columnar electrode formed on the pad of the semiconductor element according to the present invention;
Fig. 3 is a schematic sectional drawing describing a multilayer printed circuit board having a mediation layer formed on the pad of the semiconductor element according to the present invention;
Figs. 4A to 4G are schematic sectional drawings showing a part of the process for manufacturing a multilayer printed circuit board according to Embodiment 1-1 of the present invention;
Figs. 5A to 5D are schematic sectional drawings showing a part of the process for manufacturing a multilayer printed circuit board according to Embodiment 1-1 of the present invention;
Figs. 6A to 6D are schematic sectional drawings showing a part of the process for manufacturing a multilayer printed circuit board according to Embodiment 1-1 of the present invention;
Fig. 7 is an SEM image showing a cross-section of the main component of a multilayer printed circuit board according to Embodiment 2-2 of the present invention;
Fig. 8 is a schematic sectional drawing showing one example of a modification of the Embodiment 1-1 of the present invention;
Fig. 9 is a schematic sectional drawing showing another example of a modification of the Embodiment 1-1 of the present invention;
Figs. 10A to 10D are schematic sectional drawings showing a part of the process for manufacturing a multilayer printed circuit board in which a conventional semiconductor element is housed or embedded; and
Fig. 11 is a schematic sectional drawing describing a multilayer printed wiring board in which the a conventional semiconductor is housed or embedded.

### Best Embodiment to Implement the Invention

One embodiment of the multilayer printed circuit board of the present invention is characterized in that in a multilayer printed circuit board wherein, on a resin-insulating layer in which semiconductor elements are housed, another resin-insulating layer and a conductor circuit are sequentially formed, and electrical connections are established between said semiconductor elements and the conductor circuit as well as between upper and a lower conductor circuits through via holes, semiconductor elements are housed within concave portions provided in the resin-insulating layer, and semiconductor elements as well as a metal layer for mounting are formed on the bottom surface of the concave portions.

In other words, the unique point is that, by forming the metal layer on the bottom part of the concave portions of the resin-insulating layer for housing semiconductor elements, it becomes possible to make the depth of the concave portions equal, whereby it becomes avoidable for the semiconductor elements to be housed and internally accommodated in an inclined state within the concave portions, so even if a substrate for housing the semiconductor elements is made of resin, electrical connectivity or electrical reliability with a conductor circuit containing via holes that are connected thereto may be secured.

Furthermore, it is preferable for the metal layer to be internally accommodated within the substrate in advance and for it to be nearly flat. Thereby, it becomes easier to make the depth of the concave portions provided in the resin-insulating layer equal while becoming less susceptible to other factors (e.g., avoiding the effect of bumps/indents in the event of forming the concave portions and an effect in the event of having formed the metal layer).

As for the resin-insulating layer for housing the semiconductor elements to be used in the embodiments of the present invention, a hard laminated base material selected from among glass cloth epoxy resin-based material, phenol resin-based material, glass cloth bismaleimide triazine resin-based material, glass cloth polyphenylene ether resin-based material, aramid nonwoven-cloth epoxy resin-based material, aramid nonwoven-cloth polyimid resin-based material, and the like may be used. It is preferable for these to be fiber base material that is a resin material such that glass expoxy, prepreg, or a core material, has been impregnated. In addition, other materials that are generally used in a printed circuit board may be used.

For example, two-sided or one-sided copper-clad laminate, a resin plate without metal film, resin film, or combinations of these materials can be used.

The thickness range of 20-350 µm is preferable for said resin-based material. The reason is that, within such a thickness range, it is easy to secure insulating properties of an inter-layer insulating layer, and at the same time, it is easy to form via holes for inter-layer connections while also minimizing the deterioration of electrical connectivity.

In the embodiments of the present invention, the use of copper is preferable for the metal layer for forming a conductor circuit and for the metal layer to be formed on the bottom surface of the concave portions provided in the resin-insulating layer. The reason is that processing by etching is easy. Therefore, the size of the metal layer may be arbitrarily changed. Furthermore, electrical properties will be excellent even if electrical connectivity is applied to the metal layer to be formed on the bottom surface of the concave portions.

The thickness range of 5-20 µm is preferable for a copper foil for forming said conductor circuit. The reason is that, with the thickness of the copper foil being in such a range, in the event of forming openings for forming via holes in the insulating resin-based material employing laser irradiation to be described later, there is no risk of distortion of the copper foil at the periphery of the openings, and also, the formation of a conductor circuit becomes easy. Furthermore, conductor circuit patterns with a fine line width can be easily formed by etching.

The copper foil to be used in the embodiments of the present invention may be one with the thickness thereof having been adjusted by a half-etching treatment. In this case, as for the thickness of the copper foil attached to a resin-insulating layer, it is preferable to use one with values greater than the one that has been previously mentioned and to make an adjustment so that the thickness of the copper film after etching becomes 5-20 µm.

Furthermore, in the case of two-sided copper clad laminate, the thickness of the two sides may vary if the thickness of the copper foil is in said range. Thus, elimination of the following steps becomes avoidable, e.g., by ensuring strength.

As for the thickness of the copper foil as a metal layer to be formed on the bottom surface of said concave portions, 5-20 µm is preferable. The reason is that, if the thickness of the copper foil is within such a range, in the event of conducting a cavity process, the possibility of penetrating the copper foil is small, so the effects of forming the metal layer are not offset. Also, formation of the metal layer by etching becomes easy.

As for the metal layer to be provided on the bottom surface of said concave portions, besides copper, metals such as nickel, iron, cobalt, or the like may also be used. Moreover, they may also be alloys containing these metals or alloys containing two or more kinds.

Furthermore, as for said insulating resin-based material and the copper foil, in particular, it is preferable to use one-sided or two-sided copper-clad laminate obtained by laminating and thermocompressing a copper foil and a prepreg in which glass cloth is impregnated with epoxy resin to the B stage. The reason is that the wiring patterns or via hole positions do not shift during handling after the copper foil is subjected to etching, thus enabling excellent positioning precision.

In the embodiments of the present invention, the concave portions to be provided in the resin-insulating layer for housing semiconductor elements may be formed by laser processing, spot-facing processing, or by punching, and in particular, formation by laser processing is preferable.

In the case of forming said concave portions by laser processing, equal properties of the depth thereof tend to be obtained in comparison to spot-facing processing and, in particular, equal properties of depth in the metal layer are excellent. Therefore, problems regarding such issues as inclination when housing semiconductor elements may be controlled. Moreover, formation of a tapered shape, to be described later, may be accurately performed.

Additionally, when concave portions are formed by spot-facing processing, a metal layer formed on the bottom of the concave portion works as a stopper so that the depth of concave portions is equal.

The depth of said concave portions is determined in accordance with the thickness of the semiconductor element itself that is to be housed as well as the thickness of a mediation layer or of a columnar electrode that is sometimes formed on a connection pad of semiconductor elements. And because a metal layer with its entire surface being flat is formed on the bottom part of the concave portions, the thickness of an adhesive layer to be provided between the semiconductor elements and the resin-insulating layer may easily be made uniform.

Consequently, the adhesion property of the semiconductor elements and the resin-insulating layer may be uniformly maintained. Therefore, even if reliability tests under heat cycle conditions are conducted repeatedly, it becomes easy to maintain the adhesion property.

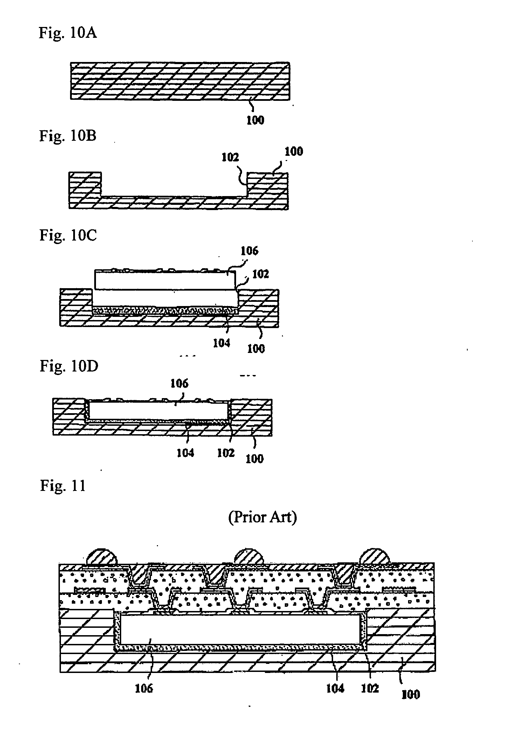

In the prior art, concave portions for housing semiconductor elements were formed in an insulating substrate composed solely of a resin-insulating layer by machining or the like. For instance, an example of the procedure for manufacturing a printed circuit board is shown in Fig. 10A-10D. As shown in Fig. 10A, first, an insulating substrate 100 composed of a resin-insulating layer is prepared. Thereafter, as shown in Fig. 10B, a concave portion 102 is formed by machining (e.g., punching, spot-facing) the insulating substrate 100. As shown in Fig. 10C and Fig. 10D, an adhesive layer 104 is formed on the bottom part of the concave portion 102 for housing semiconductor elements 106. Thereby, a printed circuit board in which the semiconductor elements 106 have been housed in the insulating substrate 100 is obtained (ref. Fig. 11).

Then, the insulating material is solely made of resin. For example, an insulating layer in which the core material was impregnated with resin has been laminated may be used. At this time, if the abovementioned machining is performed, it sometimes becomes difficult to make the concave portion flat. This is because, in the event of forming the concave portion by machining, the depth may vary or bumps/indentations are formed, depending on the state of the resin (there is a variation in the presence and presence of core material, depending on the location, as core material is woven into the resin). In the event of housing semiconductor elements, the bumps/indentations sometimes make it difficult to secure a connection between an electrode pad and via holes, depending on the inclination of the semiconductor element.

In addition, because resin that does not contain a core material is used in the insulating layer for forming via holes, it sometimes becomes difficult to ensure connection of the via holes.

Therefore, in the present invention, as for the concave portions for housing semiconductor elements, it is preferable to form the side surface thereof in a tapered shape with the end thereof spreading wider from the bottom surface in the upward direction. By forming such a shape, even in the event of being subjected to lateral stress (e.g., thermal stress, external stress, etc.) the semiconductor elements housed within the concave portions are able to mitigate the stress. Furthermore, because an adhesive provided on the bottom surface of the semiconductor element for securely bonding the semiconductor element is less likely to float along the side surface of the concave portion due to capillary action, it becomes easy to ensure the adhesion property of the semiconductor element to the bottom part of the concave portion.

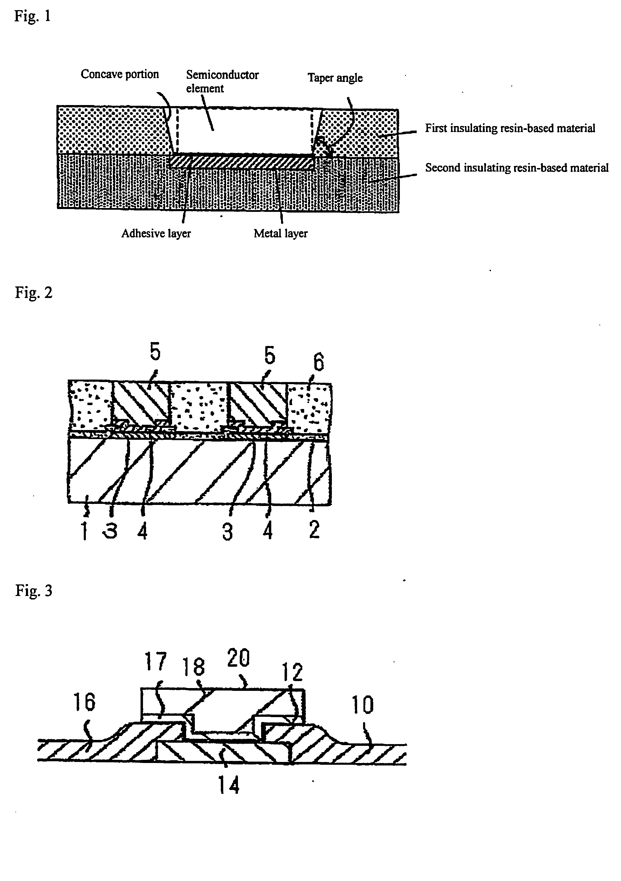

In the embodiment of the present invention, as shown in Fig. 1, the angle of the above taper is defined as the external angle formed by the side surface and the bottom surface of the concave part, and the angle of the taper is preferably greater than 60 degrees but less than 90 degrees, although a range of 60-85 degrees is more preferable. The reason is that, if the angle is within such a range, the stress at the side surface of the semiconductor element is mitigated, and displacement of the semiconductor may be controlled. Therefore, even in the event of conducting a reliability test, a connection failure at the via hole part becomes less likely at an early stage.

In the embodiments of the present invention, as one embodiment of an insulating resin layer for housing semiconductor elements, two sheets of insulating resin-based material as described above are used, that is, a first insulating resin-based material in which a metal layer with a size relative to the size of a semiconductor element has been formed on one side of the surface thereof and a second insulating resin-based material to be laminated on the surface of the side on which the metal layer of the first insulating resin-based material has been formed, are provided, and with respect to the other surface of the first insulating resin-based material, concave portions for housing semiconductor elements reaching the metal layer are formed by laser processing so as to expose the metal layer from the concave portions, in order to form a substrate for housing semiconductors. Moreover, the exposed metal layer has been internally accommodated in advance and is nearly flat.

Furthermore, as another embodiment, a substrate for housing semiconductors may also be formed by laminating a first insulating resin-based material in which a metal layer of a size relative to the size of semiconductor elements is formed on one surface and a second insulating resin-based material in which openings for a region corresponding to the metal layer have been formed in advance, and by forming concave portions in a shape with one side of the opening closed so as to form the metal layer being exposed from the concave portions.

In such an embodiment, the thickness of the first insulating resin-based material and the second insulating resin-based material is preferably 20-250 µm. The reason is that, within such a range of the thickness, it becomes easy to secure insulating properties of the inter-layer insulating layer, and at the same time, it becomes easy to form via holes for inter-layer connections while also ensuring the electrical connectivity

Furthermore, as for each insulating resin-based material, a resin-based material composed of a single layer may be used, and also a multilayered resin-based material with two or more layers of a plurality of layers may be used.

After semiconductor elements are embedded in concave portions of said substrate for housing semiconductors, and an inter-layer resin insulating layer is then formed on one side or both sides of the substrate for housing semiconductors, and after a conductor circuit containing via holes, which connects electrically to semiconductor elements, is formed on the inter-layer resin insulating layer, and furthermore, another inter-layer resin insulating layer and the conductor circuit are laminated alternately such that a multilayer printed circuit board according to the present invention can be manufactured.

As semiconductor elements to be embedded in the concave portions of said substrate for housing semiconductors, either semiconductor elements in which a columnar electrode is formed on the connection pad in advance, or semiconductor elements in which a mediation layer that coats the connection pad can be used. It is preferable that these semiconductor elements are connected electrically via the columnar electrodes or mediation layer to via holes that are provided on the inter-layer resin insulating layer.

Hereinafter, methods for manufacturing (1) semiconductor elements with columnar electrodes and (2) semiconductor elements with a mediation layer are described.
(1) A method for manufacturing semiconductor elements with columnar electrodes

Semiconductor elements with columnar electrodes used in the embodiment of the present invention refers to semiconductor elements that have columnar electrodes or rewiring.

As shown in Fig. 2, one is prepared in which a connection pad 2 made of aluminum or the like has been formed on a semiconductor element 1 (silicon substrate) in the form of a wafer, and on the upper surface thereof, a protection film 3 (passivation film) has been formed in portions other than the center part of the connection pad 2. In this state, the surface of the connection pad 2 is exposed in the center part that is not covered by the protection film 3.

Next, a foundation metal layer 4 is formed on the entire upper surface of the semiconductor element 1. As for the foundation metal layer, chrome, copper, nickel, or the like may be used.

A plating resist layer made from liquid resist is then formed on the upper surface of the foundation metal layer 4 and an opening is formed on a part corresponding to the connection pad of semiconductor elements of the plating resist layer.

Next, by electrolytic copper plating with the foundation metal layer 4 as a plating current path, a columnar electrode 5 is formed on the upper surface of the foundation metal layer within an opening part of the plating resist layer. Thereafter, once the plating resist layer is separated, and unnecessary portions of the foundation metal layer are removed through etching using the columnar electrode 5 as a mask, the foundation metal layer 4 remains only below the columnar electrode.

Furthermore, a sealing film 6 made of epoxy resin, polyimide, or the like is formed on the upper surface side of the semiconductor element 1. In this state, if the upper surface of the columnar electrode 5 has been covered by the sealing film 6, the surface thereof is polished roughly to expose the upper surface of the columnar electrode 5. Next, an individual semiconductor chip (semiconductor element having a columnar electrode) is obtained via a dicing step.
(2) A method for manufacturing semiconductor elements with a mediation layer

Mediation layer used in the embodiment of the present invention refers to an interposition layer for electrically connecting to via holes provided on the pad of the semiconductor elements.

As shown in Fig. 3, vaporization, sputtering, or the like are performed on the entire surface of semiconductor elements 10 that are to be internally accommodated to form a conductive metal layer 12 (first thin film layer) throughout the entire surface. Tin, chrome, titanium, nickel, zinc, cobalt, gold, copper, and the like are preferable for the metal. The preferred thickness for formation is in the range of 0.001-2.0 µm. The reason is that, if the thickness is within such a range, it is easy to form a metal layer with the film thickness thereof being even throughout the surface, thus making variations in film thickness less likely to arise. In the case of chrome, a thickness of about 0.1 µm is preferable.

Due to the first thin film layer 12 above, a connection pad 14 is covered, thereby making it possible to enhance the adhesion property of the interface of a mediation layer 20 and the connection pad 14 of semiconductor elements. Moreover, by covering the connection pad 14 of the semiconductor elements 10 with these metals, moisture penetration into the interface becomes preventable, thereby preventing the pad from melting or being corroded and making it less likely for the reliability thereof to be deteriorated.

As for the metal of said first thin film 12, any metal from among chrome, nickel, and titanium should preferably be used. The reason is the facilitation of a favorable adhesion property of the connection pad 14 and the metal layer 12 and also because moisture penetration into the interface is likely to be prevented.

A second thin film layer 17 is formed on said first thin film layer 12 by sputtering, vaporization, or by electroless plating. Nickel, copper, gold, silver, and the like are cited for the metal. For the electrical properties, economic property, or because a thickened layer to be formed in a later step is mainly formed from copper, so it is also prefer to form the second thin film layer 17 using copper.

The reason for a second thin film layer 17 being provided is that it is difficult for just the first thin film layer 12 to take a lead for electrolytic plating so as to form a thickened layer mentioned later. The second thin film layer 17 is used as lead for thickening.

The thickness of the second thin film layer 17 should preferably be in the range of 0.01-5.0 µm. The reason is that, if the thickness is in such a range, a role as lead may be played, and also because it is less likely to have gaps due to excessive scraping of the first thin film layer in the lower layer in the event of etching, thereby making moisture penetration less likely and facilitating easier securing of reliability.

On said second thin film layer 17, thickening is performed either by electroless or electrolytic plating. As for the types of metal to be formed, nickel, copper, gold, silver, zinc, iron, and the like are cited. For the electrical properties, economic properties, strength as a mediation layer or structural durability, or because a conductor layer of a built-up wiring layer to be formed in a later step is mainly formed from copper, so formation by electrolytic copper plating is preferable.

The thickness of a thickened electrolytic copper plating layer 18 should preferably be in the range of 1-20 µm. The reason is that, if the thickness is in such a range, connection reliability with via holes in the upper layer is less likely deteriorate, and also because it is less likely to cause undercutting in the event of etching, so it is possible to prevent gaps in the interface of a mediation layer to be formed and the via holes from being formed. Moreover, in some cases, direct thickening plating on the first thin film layer may also be performed as further multilayer lamination.

After this, an etching resist is formed, exposed and developed, metal parts except for the mediation layer are exposed for etching, and the mediation layer 20, which consists of the first thin film layer 12, the second film layer 17 and the thickened layer 18, is formed on the pad of the semiconductor elements.

In addition to the method of manufacturing said mediation layer, after semiconductor elements are embedded in the concave portions of a substrate, a mediation layer may be formed, and also, on the metal layer formed on the semiconductor elements and core substrate, a dry film resist is formed for removing the parts relevant to the mediation layer and, after being thickened by electrolytic plating, the resist is separated so that, in the same way, a mediation layer may be formed on a die pad of the semiconductor elements using an etching solution.

Next, one embodiment for manufacturing a multilayer printed circuit board according to the invention is described specifically.

### A. Manufacturing of a substrate for housing semiconductor elements

In order to manufacture a multilayer printed circuit board according to the present invention, as a substrate for housing semiconductor elements, a form in which a first insulating resin-based material and second insulating resin-based material, in which copper is attached to one side or both sides of the insulating resin-based material, are laminated is used.
(1) Said first-insulating resin-based material may, for example, be made of two-sided copper-clad laminate. Openings for forming via holes penetrating one copper foil surface of the first insulating resin-based material as well as a resin-insulating layer and reaching the other copper foil (or conductor circuit patterns) are formed by applying laser irradiation to one surface of such a two-sided copper clad laminate.

Said laser radiation is applied using a pulse-oscillatory-type carbon dioxide gas laser device, and the preferred ranges of the processing conditions are: pulse energy of 0.5-100 mJ, pulse width of 1-100 mJ, pulse duration of greater than 0.5 ms, frequency of 2,000-3,000 Hz, and the number of shots as 1-5.

The opening diameter of the openings for forming via holes to be formed and obtained under such processing conditions should preferably be 50-250 µm.

Moreover, in order to form openings for forming via holes on the copper-clad lamination by laser radiation, either a direct laser method, in which laser radiation is carried out so as to form openings on both copper foil and insulating resin-based materials, or a conformal method, in which laser radiation is carried out on insulating resin-based materials after removing copper foil parts relevant to openings for forming via holes in advance may be used.
(2) It is preferable to perform desmear treatment to remove resin residue remaining within the openings that have been formed in the preceding step.

This desmear treatment is carried out by wet processing such as chemical processing of acids or oxidizers (for example, chromic acid and permanganic acid), and dry processing such as oxygen plasma discharge treatment, corona discharge treatment, ultraviolet laser treatment, or excimer laser treatment.

A method for carrying out the desmear treatment is selected depending on the smear amount expected by the type of insulating resin-based material, thickness, diameter of openings of a via hole, and laser conditions.
(3) Filled vias are formed by electrolytic copper plating with copper foil as a lead with respect to the copper foil surface of said substrate that has been subjected to said desmear treatment and by completely filling the openings with electrolytic copper plating.

Additionally, in some cases, after electrolytic copper plating processing, it is possible to remove and planarize swelled electrolytic copper plating on the top of the opening for forming via holes of the substrate by belt-sander grinding, puff grinding, etching and the like.
(4) After forming a resist layer on both surfaces of said first insulating resin-based material, by exposure and developing steps, etching processing is performed on resist non-formation parts using an etching solution made of copper chloride or the like. Thereafter, resist is removed so as to form a conductor circuit containing via hole lands, an alignment mark for position matching, and the like on one surface of the first insulating resin-based material, and on the other surface, a metal layer having a size relative to semiconductor elements, conductor circuit containing via hole lands, positioning marks for position matching, and the like are formed.
(5) On the surface of the side where the metal layer of said first insulating resin-based material is formed, a second insulating resin-based material is laminated.

For example, a second insulating resin-based material is formed by which a copper foil is lapped on prepreg, adhesive layer, so that a laminated body is formed by thermocompressing it on the one side of the first insulating resin-based material.
(6) On the surface in which a metal layer of first insulating resin-based material that consists said laminated body is provided, laser radiation is carried out in the same way as (1) above so as to form an opening for forming via holes, which goes through the copper foil surface of the second insulating resin-based material and also reaches a conductor circuit containing a via hole area formed on the first insulating resin-based material.

Preferred processing conditions of the openings for forming via holes are: pulse energy of 0.5-100 mJ, pulse width of 1-100 µs, pulse interval of 0.5 ms or more, frequency of 2,000-3,000 Hz, and the number of shots as 1-10.

Furthermore, the opening diameter of the openings for forming via holes to be formed under said processing conditions should preferably be 50-150 µm. If the opening diameter is in such a range, it is likely to obtain security of inter-layer connectivity and high density in wiring.
(7) A desmear treatment is performed as in (2) above to remove resin residue remaining within the openings for forming via holes, which have been formed in the step of (6) above.
(8) Next, with the surface of said first insulating resin-based material coated with a protection film, electrolytic copper plating processing with the copper foil as a lead is carried out for the copper foil surface of said desmeared substrate, and electrolytic copper plating fills the opening so as to form filled vias.

Additionally, in some cases, after electrolytic copper plating processing, it is possible to remove and planarize swelled electrolytic copper plating on the top of the opening for forming via holes of the substrate by belt-sander grinding, puff grinding, etching and the like.

Furthermore, it is also possible to perform electrolytic plating after electroless plating. In this case, as for the electroless plating film, metals such as copper, nickel, silver, and the like may also be used.
(9) A resist layer is formed on said electrolytic copper plating film. As for the resist layer, the method may be either coating or attaching one that has already been shaped as a film. On the resist, a mask in which a circuit has been drawn in advance, is mounted; an etching resist layer is formed by exposure and developing; a conductor circuit containing via hole lands is formed by etching the metal layer of etching resist non-formation parts; and thereafter, the protection film that has been attached in the step of (8) above is separated.

As the etching solution, at least one kind of solution selected from among sulfuric acid-hydrogen peroxide, persulfate, copper chloride and ferric chloride is preferable.

As a pre-process for forming a conductor circuit by etching said copper foil, it is possible to adjust the thickness by etching the entire surface of the copper foil in advance so as to easily form a fine pattern.

For the via hole lands as a part of said conductor circuit, it is preferable to form the inner diameter as approximately the same as the opening diameter of the via holes, or its outer diameter as larger than the diameter of the via holes, and form the land diameter in the range of 75-350 µm.
(10) Next, in the surface region (region for housing semiconductor elements) of the opposite side from the surface on which the metal layer of the first insulating resin-based material has been provided, for example, openings penetrating the resin layer and reaching the metal layer surface are formed by laser processing, and concave portions are formed so as to expose the metal layer surface from the openings, comprising a substrate for housing semiconductor elements. When necessary, it is also possible to form concave portions so as to expose the metal layer through a resist-forming step and an etching processing step.

For example, on the laminated body with said first insulating resin-based material and said second insulating resin-based material, by laser radiation using pulsed oscillation carbon dioxide laser equipment, openings, which reach the surface of the metal layer through a resin layer from the surface of the first insulating resin-based material 30, are formed, and concave portions for housing or embedding semiconductor elements are formed.

Preferred processing conditions of the concave portions for housing said semiconductor elements are: pulse energy of 0.5-100 mJ, pulse width of 1-100 µs, pulse interval of 0.5 ms or more, frequency of 2,000-3,000 Hz, and the number of shots as 1-10.

With such laser processing, concave portions for internally accommodating semiconductor elements are formed, and the metal layer (in this case indicating a copper foil) is exposed on the bottom surface of the concave portions. Then, the metal layer is a shiny surface. Furthermore, the metal layer is nearly flat. Moreover, when necessary, the surface of the metal layer may, for example, be made rough by a blackening process or the like. Thereby, adhesion properties of the adhesive layer may also be secured.

### B. Housing and embedding semiconductor elements

(11) Semiconductor elements are embedded in the substrate for housing semiconductor elements, which has been obtained via the steps of (1) through (10) in A above.

For the semiconductor elements to be embedded, as mentioned above, either semiconductor elements, in which columnar electrodes are formed on the connection pad in advance, or semiconductor elements, in which a mediation layer for coating the connection pad is formed, may be used; however, the case in which the latter is used is described hereto.

This mediation layer is a mediation layer that is provided for connecting the pad of semiconductor elements and a conductor circuit containing via holes of a printed circuit board directly. It is formed by a thin film layer being provided on the die pad, and furthermore, a thickened layer being provided on the thin film layer, and preferably, it is formed by at least more than two layers.

Furthermore, it is preferable to form the mediation layer in a size that is larger than the die pad of the semiconductor elements. By making it such a size, position matching with the die pad becomes easy. As a result, electrical connectivity with the die pad improves, and also via hole processing by laser radiation or photo-etching becomes possible without damaging the die pad. Therefore, embedding and housing of semiconductor elements in a printed circuit board, and electrical connections, are performed with assurance.

Moreover, on the mediation layer, a metal layer consisting of a conductor circuit of a printed circuit board can be formed.

Additionally, in addition to the manufacturing methods mentioned above, on a metal film formed on the entire surface of the side where a connection pad of semiconductor elements or on the substrate for housing semiconductor elements where semiconductor elements are embedded, a resist made from dry film is formed so as to remove parts relevant to the mediation layer, and then the metal layer is thickened by electrolytic plating, and finally, the resist is separated so that a mediation layer can be formed on the connection pad of semiconductor elements using an etching solution in the same way.
(12) On the substrate in which semiconductor elements have been housed and internally accommodated, after providing an insulating resin layer, by performing the same processes as in (1) through (4) in A above, via holes to be electrically connected to the mediation layer that has been formed on the connection pad of the internally accommodated semiconductor elements, via holes to be electrically connected to a conductor circuit containing via holes that have been formed in the substrate for housing semiconductor elements, and a conductor circuit of the outside may be formed. Then, a matte treatment may also be performed to the conductor circuit on the substrate and the metal layer. In matte processing, a technology for forming a matte surface may be used by making the metal layer rough via etching, plating, oxidation reduction treatment, blackening treatment, or the like.

Furthermore, by laminating an insulating resin layer and a copper foil and by repeating the same treatment as in (1) through (4) of A above, a printed circuit board with more layers may be obtained.

In the abovementioned method, although resin insulating layers are laminated successively to make the resin insulating layer multilayered, if needed, by laminating one unit of a circuit substrate such that there are more than two layers and thermocompressing them all together, a multilayer printed circuit board, which makes the resin insulating layer multilayered, may be provided.
(13) Next, a solder resist layer is formed on the surface of the outer most side of the circuit substrate. In this case, by coating the entire outer surface of the circuit substrate with a solder resist composite and after drying the coated film, on the coated film, a photo mask film in which opening parts of a solder pad have been drawn, is mounted, subjected to exposure and developing, to form a solder pad opening in which a conductive pad portion located directly above a via hole of the conductor circuit is exposed. In this case, the openings may also be formed by attaching a solder resist layer that has been made into a dry film through exposure, developing, or laser irradiation.

On the solder pad that has been exposed from the non-formation part of said mask layer, a corrosion layer composed of nickel-gold or the like is formed. Then, the preferred thickness of the nickel layer should be 1-7 µm, and the preferred thickness of the gold layer should 0.0 1-0. µm.

In addition, layers of nickel-palladium-gold, gold (single layer), silver (single layer), or the like may also be formed. After forming the corrosion layer, the mask layer is separated. Thereby, a printed circuit board is provided in which a mixture of a solder pad on which a corrosion layer has been formed and a solder pad on which a corrosion pad has not been formed are present.
(14) By supplying a solder body to the solder pad portion that is exposed directly above via holes from the openings of the solder resist that was obtained in the step of (13) above, a multilayer printed circuit board is formed in which a solder layer has been formed due to melting and hardening of the solder body. Alternatively, solder bumps and conductive balls or conductive pins may also be bonded to the pad part using a conductive adhesive or a solder layer.

The solder transfer process hereto is a method for transferring, by which solder foil is put on the prepreg and the solder foil is etched leaving a part relevant to the opening so as to form a solder pattern as a solder carrier film, and the solder carrier film is laminated and heated such that the solder pattern touches the pad after the solder resist opening of the substrate is coated with flux.

On the other hand, the printing method is a method of thermo treatment in which a print mask (metal mask) provided with openings at a location equivalent to that of the pad is mounted on a substrate, and solder paste is printed. As for the solder for forming such a solder layer, Sn/Ag solder, Sn/In solder, Sn/Zn solder, Sn/Bi, or the like may be used.

### (Embodiment 1-1)

### (1) Preparation of the base material

First, a printed substrate constituting a substrate for housing semiconductor elements is manufactured. The printed substrate comprises a first insulating base material 30 as well as a second insulating base material 40 and is formed by laminating these base materials. As an example of materials for the printed substrate, a two-sided copper-clad laminate obtained by laminating and thermocompressing a copper foil and a prepreg in which epoxy based resin has been impregnated in a glass cloth to B stage is used as a starting material.

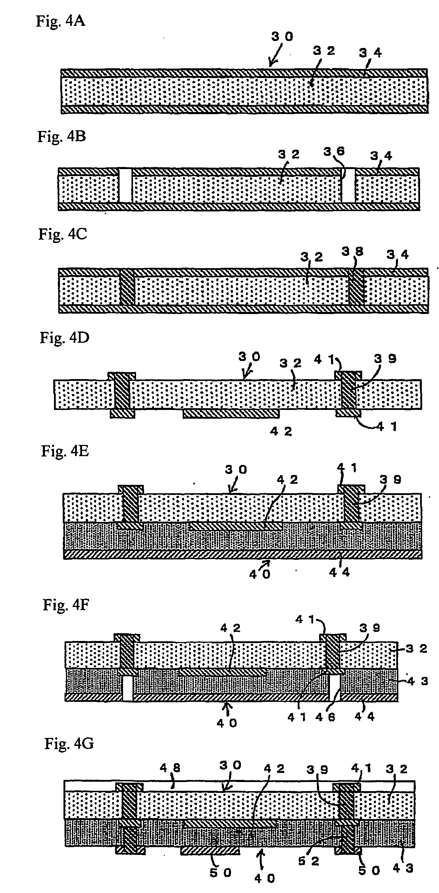

A two-sided copper-clad laminate, composed by attaching a copper foil 34 with a thickness of 15 µm onto both surfaces of a resin-insulating layer 32 with a thickness of 100 µm, is used as said first insulating base material 30. It is also possible to use a laminate with a copper foil 32 that is thicker than 15 µm and to adjust the thickness of the copper foil to 15 µm via etching treatment (ref. Fig. 4A).

Furthermore, on a surface of the first insulating base material that comes to contact with the second insulating base material, a metal layer on the bottom surface of concave portions where semiconductor elements are internally accommodated, a conductor circuit, and the like have been formed through resist and etching treatment. When necessary, a positioning mark for position matching in opening holes with a laser or the like may also be formed.

### (2) Formation of openings for forming via holes

On one copper foil surface of said first insulating base material 30, a carbon dioxide laser is irradiated to form openings 36 for forming via holes penetrating the copper foil 34 as well as the resin-insulating layer 32 and reaching the other copper foil surface (ref. Fig. 4B). Furthermore, the inside of the openings is subjected to a desmear treatment by a permanganic chemical solution treatment.

In this embodiment, a high-peak short pulse oscillation carbon dioxide laser beam machine by Hitachi Via Mechanics, Ltd., is used to form the openings 36 for forming via holes, and openings for forming via holes with a diameter of 75 µm are formed by irradiating a glass cloth epoxy resin-based material having a base material thickness of 60 µm at a rate of 100 holes/sec. under the following radiation conditions.

| (Radiation conditions) | |
|---|---|
| Pulse energy: | 75mJ |
| Pulse duration: | 80 µs |
| Pulse interval: | 0.7 ms |
| Frequency: | 2000 Hz |

### (3) Formation of electrolytic copper plating film

An electrolytic copper plating treatment with a copper foil as a plating lead is performed under the following conditions on the copper foil surface where the openings 36 for forming via holes of the first insulating base material 30, which had undergone the desmear treatment, are provided.

| [Electrolytic plating solution] | |
|---|---|
| Sulfuric acid | 2.24 mol/l |
| Copper sulfate | 0.26 mol/l |
| Additive A (reaction accelerator) | 11.0 ml/l |
| Additive B (reaction inhibitor) | 0.34 fl oz/l |

| [Electrolytic plating conditions] | |
|---|---|
| Current density | 1 A/dm² |
| Time | 65 minutes |
| Temperature | 22±2°C |

With such a plating treatment, the formation of electrolytic copper plating film 38 within the openings is accelerated due to the additive agent A, while formation of the plating film is inhibited due to adhesion mainly to the copper foil portion by the additive agent B. Furthermore, the electrolytic copper plating fills the inside of the openings, and if the height reaches up to about the same level as the copper foil, only the additive agent B adheres, so formation of the plating film is inhibited as in the copper foil portion. Thereby, the electrolytic copper plating completely fills the inside of the openings, and the electrolytic copper plating 38 exposed from the openings as well as the copper foil 34 are made nearly flat (ref. Fig. 4C).

Moreover, it is also possible to adjust the thickness of the conductor layer comprising the copper foil 34 and the electrolytic plating film 38 by etching. In some cases, the thickness of the conductor layer may also be adjusted by a physical method such as belt-sander grinding and buffing.

### (4) Formation of the conductor circuit, filled vias, and the metal layer

On the copper foil 34 and the copper plating film 38 of the first insulating base material 30 that has undergone the step in (3) above, a photosensitive dry film is used to form an etching resist layer (illustration omitted). In other words, the etching resist layer is formed on both of the copper foil surfaces of the first insulating base material 30. The thickness of the resist layer is within the range of 15-20 µm, and resist non-formation parts are formed on the copper foil through exposure and developing using a mask in which a conductor circuit containing lands of filled vias as well as a metal layer of a size relative to the size of the semiconductor elements have been drawn.

Next, the resist non-formation part is etched using an etching solution made from hydrogen peroxide solution/sulfuric acid so as to remove copper plating film and copper foil that are relevant to the non-formation part.

Thereafter, a conductor circuit 41 containing the lands of filled vias 39 as well as a metal layer 42 for contacting semiconductor elements are formed by separating the resist with an alkali solution. As needed, dummy patterns, alignment marks, product identification symbols, or the like may also be formed.

Thereby, a circuit substrate is composed and obtained by forming the conductor circuit 41 on the front surface as well as the back surface of the first insulating base material 30 and also forming the filled vias 39 for electrically connecting these conductor circuits 42 further by forming the metal layer 42 for mounting semiconductor elements.

Moreover, as shown in Fig. 1, the metal layer 42 to be formed in the circuit substrate is formed on the back surface of the first insulating base material, and the copper foil portion of the circuit substrate surface equivalent of regions, where concave portions for housing semiconductor elements are formed, is removed by etching (ref. Fig. 4D). (5) Lamination of first insulating base materials and second insulating base materials For the second resin base material 40 to be laminated with said first insulating base material 30, a one-sided copper-clad laminate on which a copper foil 44 with a thickness of 15 µm is attached on one surface of a resin-insulating layer 43 having a thickness of 60 µm is used.

Such second insulating base material 40 is laminated with a surface of the side on which the copper foil has not been formed while being in a state of contact with the surface on which the metal layer 42 of the first insulating base material 30 has been formed (the metal layer 42 becomes a metal layer for mounting semiconductor elements). The lamination of the first insulating base material 30 and the second insulating base material 40 are performed by thermocompressing both of these under the following conditions. Then, a treatment for forming a mat surface (e.g., coarse surface formation or the like by an etching treatment) on a conductor layer 41 and the metal layer 42 may also be performed.

| (Crimping conditions) | |
|---|---|
| Temperature: | =180°C |
| Pressing pressure: | 150 kgf/cm² |
| Compressing duration: | 15 minutes |

Furthermore, in this embodiment, the first insulating base material 30 and the second insulating base material 40 are formed in a single layer, but it is also possible to form the same in a plurality of layers with more than two layers.

### (6) Formation of openings for forming via holes

With respect to the copper foil formation surface of said second insulating base material 40, a carbon dioxide gas laser is irradiated to form openings 46 for forming via holes penetrating a copper foil 44, passing a resin-insulating layer 43, and reaching the conductor circuit 41 surface, including via lands of the filled vias provided in said first insulating base material 30 (ref. Fig. 4F). Furthermore, the inside of the openings is subjected to a desmear treatment by permanganic chemical solution treatment.

In this embodiment, a high-peak short pulse oscillation carbon dioxide laser beam machine by Hitachi Via Mechanics, Ltd., is used to form openings 46 for forming via holes in the second insulating base material 40. And the openings 46 for forming via holes with a diameter of 75 µm are formed by directly irradiating the copper foil 44 that has been attached to the glass cloth epoxy resin-based material 43 having a base material thickness of 60 µm of the second insulating base material 40 at a rate of 100 holes/sec. under the following radiation conditions.

| (Radiation conditions) | |
|---|---|
| Pulse energy: | 75mJ |
| Pulse duration: | 80 µs |
| Pulse interval: | 0.7 ms |
| Frequency: | 2000 Hz |

### (7) Formation of electrolytic copper plating film

After covering the surface of said first insulating base material 30 by attaching a protective film 48, an electrolytic copper plating treatment with a copper foil as a plating lead is performed under the following plating conditions on the copper foil surface of the second insulating base material 40 that has undergone the desmear treatment of the inside of the openings.

| [Electrolytic plating solution] | |
|---|---|
| Sulfuric acid | 2.24 mol/l |
| Copper sulfate | 0.26 mol/l |
| Additive A (reaction accelerator) | 11.0 ml/l |
| Additive B (reaction inhibitor) | 10.0 ml/l |

| [Electrolytic plating conditions] | |
|---|---|
| Current density | 1A/dm² |
| Time | 65 minutes |
| Temperature | 22±2°C |

In such a plating treatment, the formation of an electrolytic copper plating film within the openings is accelerated due to the additive agent A, while formation of the plating film is inhibited due to adhesion mainly to the copper foil portion by the additive agent B. Furthermore, the electrolytic copper plating fills the inside of the openings, and if the height reaches approximately the same level as the copper foil, only the additive agent B adheres, so formation of the plating film is inhibited as in the copper foil portion. Thereby, the electrolytic copper plating completely fills the inside of the openings, and the electrolytic copper plating exposed from the openings as well as the copper foil 34 are made nearly flat.

Moreover, it is also possible to adjust the thickness of a conductor layer comprising copper foil and electrolytic plating film by etching. In some cases, the thickness of the conductor layer may also be adjusted by a physical method such as belt-sander grinding and buffing.

### (8) Formation of conductor circuits and filled via holes

On the copper foil 44 of the second insulating based material 40 and copper plating, which were processed in (7) above, an etching resist layer (figure omitted) is formed using photosensitive dry film. The thickness of the resist layer is within a range of approximately 15 µm to 20 µm, and a resist non-formation part is formed on the copper foil through processes of exposure/development using a mask, on which conductor circuits containing a land of filled via holes are drawn.

Next, the resist non-formation part is etched using an etching solution made from hydrogen peroxide solution/sulfuric acid so as to remove copper plating film and copper foil that are relevant to the non-formation part.

Thereafter, the resist is separated in an alkaline solution, and the protection film 48 attached to the surface of the first insulating base material 30 in the process of (7) above is then separated, and thus, on one surface of the second insulating base material 40, a conductor circuit 50 is formed, and also filled via holes 52 that electrically connect these conductor circuits to the land 41 of the filled via holes 39 provided on the first insulating base material 30 are formed (Refer to Fig. 4G). If needed, dummy patterns, alignment marks, product recognition symbols, and the like can be formed.

### (9) Formation of concave portions for housing semiconductor elements

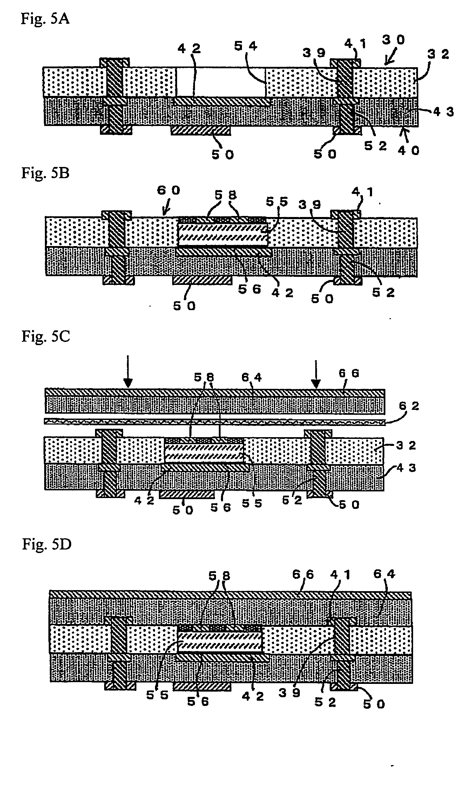

In the process of (4) above, carbon dioxide laser radiation is applied to the resin part from which the copper foil part was removed by etching so as to form openings that reach the surface of a metal layer through a resin layer. The metal layer is exposed in the openings, and with the sides of the openings and the surface of the metal layer (bottom), concave portions 54 for embedding semiconductor elements 55 are formed (Refer to Fig. 5A).

According to the embodiment, in order to form concave portions 54 for housing semiconductor elements on the first insulating resin-based material 30, a high-peak short-pulse oscillation carbon dioxide laser beam machine by Hitachi Via Mechanics, Ltd. is used. For areas in which copper foil on the surface of the first insulating base material is removed, laser radiation is applied to a glass fabric epoxy resin-based material with a base material thickness of 60 µm under the following radiation conditions so as to form a concave portion 54, which is slightly larger than the size of the semiconductor elements to be housed and has a depth of approximately 100 µm, for housing semiconductor elements.

### (Radiation conditions)

Pulse energy = 100 mJ
Pulse duration = 90 µs
Pulse interval = 0.7 ms
Frequency = 2000 Hz
Additionally, the metal layer 42 is exposed on the bottom of the concave portion 54 for housing semiconductor elements formed by laser processing, and the depth of the concave portion 54 is almost equal and the shape of the four corners is not a circular arc. At this time, the surface of the metal layer on which the semiconductor elements are placed is a shiny surface. However, if needed, the surface of the metal layer may be roughened to a certain degree, for example, by a blackening process or the like to ensure adhesiveness to the adhesive layer. Moreover, the area of the concave portions is smaller than the area of the metal layer. Thus, uniformity of the depth of the concave portions can easily be ensured.

### (10) Housing semiconductor elements with columnar electrodes

For semiconductor elements 55 for housing and embedding in the concave portion 54 of substrates for housing semiconductor elements that are manufactured according to the processes of (1) to (9) above, semiconductor elements with columnar electrodes, which are manufactured according to the process of the following (a) to (d), are used.

### (a) Preparation of silicon substrate

A connection pad is formed on a wafer silicon substrate (semiconductor substrate); a protection film (passivation film) is formed on the connection pad excluding the center part; and the center of the connection pad is exposed through the openings formed on the protection film.

### (b) Formation of foundation metal layer

On the entire upper surface of the silicon substrate, a foundation metal layer made of copper with a thickness of 2 µm is formed by sputtering.

### (C) Formation of columnar electrodes

Next, on the upper surface of the foundation metal layer, a dry film resist made of a photosensitive resin such as acrylic resin is laminated so as to form a plating resist layer with a thickness of 110 µm. The height of columnar electrodes to be formed is set at about 100 µm.

Thereafter, openings are formed on the resist through a processes of exposure/development using a mask, on which an opening is drawn on a part relevant to the pad on the plating resist layer.

Furthermore, by electrolytic copper plating with the foundation metal layer as a plating current path, columnar electrodes made from copper are formed on the upper surface of the foundation copper layer in the openings of the plating resist layer.

Finally, after the plating resist layer is separated and unnecessary parts on the foundation metal layer are etched using columnar electrodes as a mask, the foundation metal layer remains only below the columnar electrodes.

### (d) Formation of sealing film

On the upper surface of the silicon substrate obtained in (c) above, a sealing film, which is an insulating resin made from epoxy resin or polyimide, is formed. In this state, if the upper surface of the columnar electrodes is coated with the sealing film, the surface is ground properly such that the upper surface of the columnar electrodes is exposed.

Next, individual semiconductor chips (semiconductor equipment) are obtained by a dicing process. At this time, semiconductor elements with columnar electrodes are formed so as to have a thickness of 100 µm.

On the lower surface of the semiconductor element 55, which is manufactured according to the processes of (a) to (d) above, a thermosetting adhesive, for example, an adhesive made from thermosetting resin, in which a part of epoxy resin is acrylized, is applied so as to form an adhesive layer 56 with a thickness of 30 µm to 50 µm.

After housing in the concave portion 54 of the substrate for housing semiconductor elements, the adhesive layer 56 is hardened by heating at 100°C to 200°C. By this means, a substrate 60 on which semiconductor elements 55 are embedded is obtained (Refer to Fig. 5B).

At this time, the tip of the columnar electrodes 58 of the semiconductor elements and the upper surface of the substrate are almost on the same surface. In other words, the semiconductor element 55 does not incline, and the electrode pad is nearly flat.

### (11) Lamination process

An adhesive layer 62 such as prepreg is placed on the substrate 60 that was obtained in (10) above, and a one-sided copper-clad lamination is formed by attaching a copper foil 66 with a thickness of 15 µm laminated on one surface of the resin insulating layer 64 with a thickness of 60µm (Refer to Fig. 5C) so as to make them multilayer under the following conditions (Refer to Fig. 5D).

| (Pressing conditions) | |
|---|---|
| Temperature: | 190°C |
| Pressure: | 3.0 kgf/cm² |
| Pressing time: | 35 minutes |

### (12) Formation of openings for forming via holes

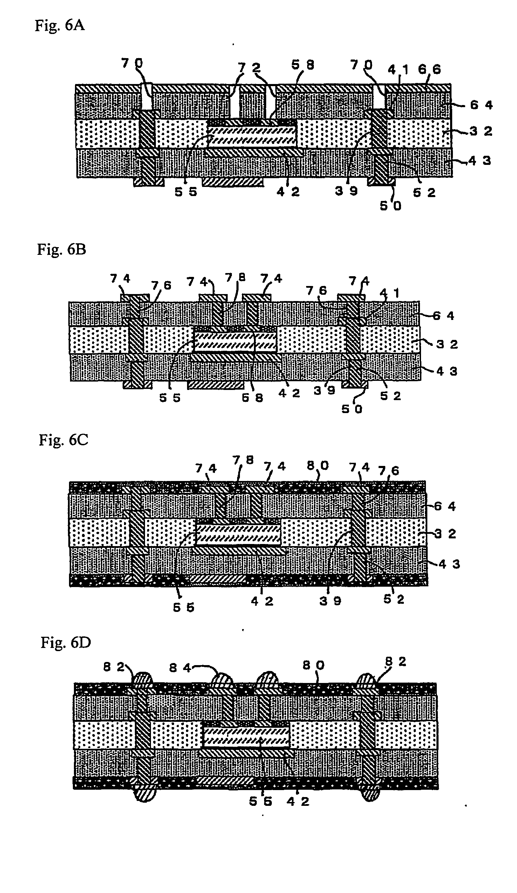

In the same way as the process of (6) above, the conductor circuit 41 containing via-land that is formed on the first insulating base material comprising the substrate for housing semiconductor elements through the copper foil 66 and the resin-insulating layer 64, and openings for forming via holes 70 and 72 that each reach the columnar electrode 58 provided on the pad on semiconductor elements, are formed (Refer to Fig. 6A). The laser radiation conditions in this case are the same as the process of (6) above. Furthermore, the inside of the openings are desmeared by chemical treatment using permanganic acid.

### (13) Formation of electrolytic copper plating

Electrolytic copper plating using copper foil as the plating lead is carried out on the copper foil surface, in which the inside of the openings has been desmeared, under the following plating conditions.

| [Electrolytic plating solution] | |
|---|---|
| Sulfuric acid | 2.24 mol/l |
| Copper sulfate | 0.26 mol/l |
| Additive A (reaction accelerator) | 10.0 ml/l |
| Additive B (reaction inhibitor) | 10.0 ml/l |

| [Electrolytic plating conditions] | |
|---|---|
| Current density | 1 A/dm² |
| Time | 65 minutes |
| Temperature | 22±2°C |

According to such a plating process, Additive A accelerates the formation of an electrolytic copper plating film in the openings, and conversely, Additive B mainly adheres to copper foil parts so as to inhibit the formation of a plating film. Additionally, when the inside of the openings are filled with electrolytic copper plating so as to be almost the same height as the copper foil, Additive B is adhered, and thus, the formation of a plating film is inhibited in the same way as for the copper foil part. Accordingly, the insides of the openings are completely filled with electrolytic copper plating, and also, the electrolytic copper plating and copper foil exposed from the openings are formed so as to be nearly flat.

Moreover, it is possible to adjust the thickness of a conductive layer made from copper foil and electrolytic plating film by etching. In some cases, the thickness of the conductive layer may be adjusted using physical methods such as belt sander grinding and buffing.

Accordingly, via holes connected to conductor circuits and via holes connected to the host of semiconductor elements are formed, by which the insides of the openings are completely filled with electrolytic copper plating.

### (14) Formation of conductor circuits

On copper foil and copper plating through a process of (13) above, an etching resist layer is formed using a photosensitive dry film. The thickness of the resist layer is within a range of 15 µm to 20 µm, and a resist non-formation part is formed on the copper foil through processes of exposure/development using a mask, on which conductor circuits containing a land of filled via holes are drawn.

Next, the resist non-formation part is etched using an etching solution made from hydrogen peroxide solution/sulfuric acid so as to remove copper plating film and copper foil that are relevant to the non-formation part.

After that, by separating the resist using an alkaline solution, a conductor circuit 74 is formed on the resin-insulating layer 64 provided by coating the substrate for housing semiconductor elements 60, and also filled via holes 76 that electrically connect the conductor circuit 74 to the land 41 of the filled via holes and filled via holes 78 that are electrically connected to the columnar electrodes 58 provided on the pad of semiconductor element 55 are formed respectively. Additionally, if needed, dummy patterns, alignment marks, product recognition symbols and the like can be formed.

Furthermore, if needed, repeating the processes of (11) to (14) above can provide a further multilayer printed circuit board.

Moreover, in order to make such a multilayer, it is possible to laminate so as to make the orientation of the via holes the same or opposite. Additionally, combinations other than the above are acceptable in order to make a multilayer.

### (15) Formation of solder resist layer

A solder resist layer 80 is formed on the surface of the circuit substrate located on the top layer or bottom layer of the multilayer substrate obtained according to the process of (1) to (14) above. By attaching a film-formed solder resist or coating with varnish, the viscosity of which has been adjusted in advance, a solder resist layer 80 with a thickness of 20 µm to 30 µm is formed on the substrate.

Next, after drying at 70°C for 20 minutes and at 100°C for 30 minutes, the side, on which the chromium layer was formed, of a soda lime glass substrate with a thickness of 5 mm, on which a circular pattern (mask pattern) of the opening of the solder resist was drawn by the chromium layer, is adhered to the solder resist layer, and is exposed with 1,000 mJ/cm² of ultraviolet rays, and DMTG development was carried out. Furthermore, by heating under the conditions of 120°C for 1 hour and 150°C for 3 hours, a solder resist layer 80 (20 µm thick) with an opening 82 (200 µm diameter of the opening) relevant to the pad part is formed.

Additionally, if needed, it is possible to provide a rough layer on the surface of the circuit substrate located on the top layer and bottom layer of the multilayer substrate. In this case, a mask layer, formed so as to be in the form of a dry film made from photosensitive resin, is formed on the solder resist layer. By attaching the mask layer formed like a film or by coating with varnish, the viscosity of which has been adjusted in advance, a mask layer with a thickness of 10 µm to 20 µm is formed on the solder resist layer.

Next, after drying at 80°C for 30 minutes, the side, on which the chromium layer is formed, of the soda lime glass substrate with a thickness of 5 mm, on which a formation pattern (mask pattern) of the mask layer is drawn by the chromium layer, is adhered to the solder resist layer, and is exposed with 800 mJ/cm² of ultraviolet rays, and DMTG development is carried out. Furthermore, by heating at 120°C for 1 hour, a solder resist layer (20 µm thick) is formed.

### (16) Formation of corrosion-resistant layer

Then, the substrate, where the solder resist layer 80 is formed, is immersed in an electroless nickel plating solution of pH=5 made from nickel chloride 30 g/l, sodium hypophosphite 10 g/l, and sodium citrate 10 g/l for 20 minutes so as to form a nickel plating layer with a thickness of 5 µm at the opening.

Furthermore, the substrate is immersed in an electroless plating solution made from potassium gold cyanide 2 g/l, ammonium chloride 75 g/l sodium citrate 50 g/l and sodium hypophosphite 10 g/l at 93°C for 23 seconds so as to form a gold plating layer with a thickness of about 0.03 µm on the nickel plating layer and a metal coating layer (figure omitted) formed by a nickel plating layer and gold plating layer.

### (17) Formation of solder layer

Accordingly, on the solder pad that is exposed from the opening 82 of the solder resist layer 80 coating the multilayer circuit substrate on the top layer, by printing Sn/Pb solder with a melting point of 183°C or solder paste made from Sn/Ag/Cu, and reflowing at 183°C, a solder layer 84 is formed.

### (Embodiment 1-2)

With the exception of the process for embedding semiconductor elements 55 with a mediation layer, which is manufactured in the following processes of (a) to (c) in the concave portion 42 of the substrate for housing semiconductor elements, a multilayer printed circuit board is manufactured via the same process as Embodiment 1-1.
(a) Entirely on the semiconductor elements with a protection film on the connection pad and wiring pattern, two layers, a chromium thin film with a thickness of 0.1 µm and a copper thin film layer with a thickness of 0.5 µm, are successively formed in a vacuum chamber by sputtering.
(b) Thereafter, a resist layer made from dry film is formed on a thin film layer. A mask with drawn parts forming a mediation layer is placed on the resist layer, and a resist non-formation part is formed via the processes of exposure and development. A thickened layer (electrolytic copper plating film) having a thickness of 10 µm is provided on the resist non-formation part by electrolytic copper plating.
(c) After removing the plating resist using an alkaline solution, a mediation layer is formed on the pad of semiconductor elements by removing the metal layer below the plating resist using an etching solution.

Accordingly, a semiconductor element is obtained which is 5 mm long, 5 mm wide and 100 µm thick.

### (Embodiment 2-1)

In the process of A (6) above, a multilayer printed circuit board was manufactured via the same processes as Embodiment 1-1, with the exception of the process for forming a taper with a 85-degree angle on the side of the concave portion for housing semiconductor elements.

### (Embodiment 2-2)

In the process of A (6) above, a multilayer printed circuit board was manufactured via the same processes as Embodiment 1-1, with the exception of the process for forming a taper with a 75-degree angle on the side of the concave portion for housing semiconductor elements.

At this time, a part of the resin-insulating layer containing prepreg coating of semiconductor elements housed in the concave portions is filled into the space between the sides of the semiconductor elements and the wall part of the concave portions, and the resin-insulating layer is unified with the adhesive layer that fixes the semiconductor elements to the bottom of the concave portions.

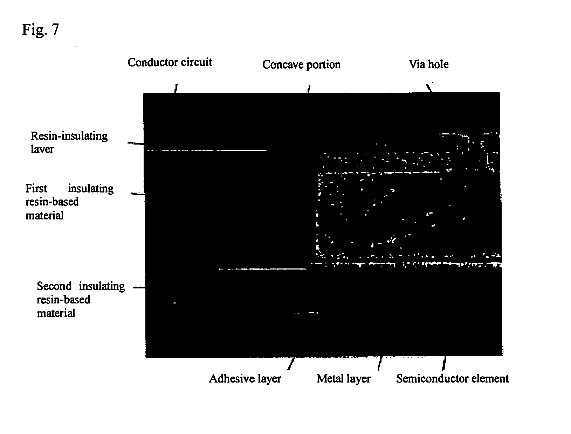

Fig. 7 is an example of an SEM picture showing a cross-section of the substantial part of such multilayer printed circuit board, and dummy elements are used for semiconductor elements to be housed in the concave portions.

### (Embodiment 2-3)

In the process of A (6) above, a multilayer printed circuit board was manufactured via the same processes as Embodiment 1-1, with the exception of the process for forming a taper with a 60-degree angle on the side of the concave portion for housing semiconductor elements.

### (Embodiment 2-4)

In the process of A (6) above, a multilayer printed circuit board was manufactured via the same processes as Embodiment 1-1, with the exceptions of the process for forming a taper with an 85-degree angle on the side of the concave portion for housing semiconductor elements and of the use of semiconductor elements having a mediation layer as semiconductor elements to be housed in the concave portions.

### (Embodiment 2-5)

In the process of A (6) above, a multilayer printed circuit board was manufactured via the same processes as Embodiment 1-1, with the exceptions of the process for forming a taper with a 75-degree angle on the side of the concave portion for housing semiconductor elements and of the use of semiconductor elements having a mediation layer as semiconductor elements to be housed in the concave portions.

### (Embodiment 2-6)

In the process of A (6) above, a multilayer printed circuit board was manufactured via the same processes as Embodiment 1-1, with the exceptions of the process for forming a taper with a 60-degree angle on the side of the concave portion for housing semiconductor elements and of the use of semiconductor elements having a mediation layer as semiconductor elements to be housed in the concave portions.

### (Embodiment 3)

As the substrate for housing semiconductor elements, a multilayer printed circuit board was manufactured via the same processes as Embodiment 1-1, with the exception of the use of a substrate formed by laminating a first insulating resin in which a metal layer relevant to the size of the semiconductor elements is formed on one surface, and a second insulating resin-based material in which an opening is formed in advance in an area relevant to the metal layer and by forming the concave portions, in which one end of the opening is closed, so as to expose the metal layer from the concave portions.

### (Reference Example 1-1)

In the process of A (6) above, a multilayer printed circuit board was manufactured via the same processes as Embodiment 1-1, with the exception of the process for forming a taper with a 55-degree angle on the side of the concave portion for housing semiconductor elements.

### (Reference Example 1-2)

In the process of A (6) above, a multilayer printed circuit board was manufactured via the same processes as Embodiment 1-1, with the exceptions of the process for forming a taper with a 55-degree angle on the side of the concave portion for housing semiconductor elements and of the use of semiconductor elements having a mediation layer as semiconductor elements to be housed in the concave portions.

### (Comparative Example 1-1)

A multilayer printed circuit board was manufactured via the same processes as Embodiment 1-1, with the exceptions of not forming a metal layer on the first insulating resin-based material and of forming concave portions to be provided on the first insulating resin-based material by spot-facing processing such that the bottom of the concave portions would not reach a second insulating resin base material.

### (Comparative Example 1-2)

A multilayer printed circuit board was manufactured via the same processes as Embodiment 1-2, with the exceptions of not forming a metal layer on the first insulating resin-based material and of forming concave portions to be provided on the first insulating resin-based material by a spot-facing process such that the bottom of the concave portions would not reach a second insulating resin base material.

An evaluation test of Section A was conducted in a substrate in which dummy semiconductor elements (made of silicone) with a thickness of 250 µm had been implanted, as semiconductor elements, in the concave portions of the substrate for housing semiconductor elements created according to each of the above Embodiments, Reference Examples, and Comparative Examples, fixed to the bottom of the concave portions using the adhesive used in Embodiment 1-1, and moreover, evaluation tests of Sections B and C were conducted in a multilayer printed circuit board created according to each of the above Embodiments and Comparative Examples. The results of each evaluation test are shown in Table 1.

### A. Tensile strength test

Dummy semiconductor elements were implanted in concave portions of a substrate for housing semiconductor elements and fixed with an adhesive, a 4-mm metal fragment with a handle was adhered and fixed to the center of the upper surface of the dummy semiconductor elements using an instant adhesive (e.g., product name "ARON ALPHA"), the tip of a spring balance was hooked onto the handle, and the spring was pulled in the vertical direction, in order to measure the strength when the dummy semiconductor elements came off.

### B. Resistance measurement test

The presence or absence of conduction of a conductor circuit to be connected to semiconductor elements implanted in a multilayer printed circuit board was measured at ten spots, and the number of spots showing conductivity was compared.

### C. Reliability test

A heat cycle test with one cycle of 130°C/3 min. ⇔ -55°C/3 min. was conducted for up to 2,000 cycles, and thereafter, every 200 cycles, a conduction test was conducted after leaving for 2 hours after completion of the test, in order to measure the presence or absence of circuits having a resistance change of over 20% and to compare the number of cycles showing over 20%.

**Table 1**

| | Metal layer | Taper angle of concave portions (degrees) | Tensile test (kgf) | Continuity test (spots) | Reliability test (Number of cycles) |
|---|---|---|---|---|---|
| Embodiment 1-1 | With | 90 | 4.2 | 9 | 1,800 |
| Embodiment 1-2 | With | 90 | 4.1 | 10 | 1,800 |
| Embodiment 2-1 | With | 85 | 4.9 | 10 | 1,800 |
| Embodiment 2-2 | With | 85 | 4.3 | 10 | 2,000 |
| Embodiment 2-3 | With | 75 | 4.2 | 10 | 1,800 |
| Embodiment 2-4 | With | 75 | 4.7 | 9 | 2,000 |
| Embodiment 2-5 | With | 60 | 4.5 | 10 | 2,000 |
| Embodiment 2-6 | With | 60 | 4.3 | 10 | 2,000 |
| Reference Example 1-1 | With | 55 | 4.0 | 9 | 1,600 |
| Reference Example 1-2 | With | 55 | 4.1 | 10 | 1,800 |
| Comparative Example 1-1 | Without | - | 2.3 | 3 | 1,000 |
| Comparative Example 1-2 | Without | - | 2.0 | 4 | 1,000 |

According to the above test results, it was verified that a multilayer printed circuit board related to each Embodiment in which concave portions for housing semiconductor elements are formed in a resin-insulating layer and also a metal layer that contacts the semiconductor elements is formed on the bottom of the concave portions, was drastically superior to a multilayer printed circuit board related to Comparative Examples in which a metal layer that contacts the semiconductor elements is not formed on the bottom of the concave portions with respect to adhesiveness, electronic connectivity, connection reliability, and heat cycle resistance.

Moreover, in the case in which a tapered angle is provided on the sides of the concave portions, it was confirmed that because the housed semiconductor elements was able to reduce thermal stress, external stress, or the like in the lateral direction, they had excellent heat cycle resistance, and regarding the adhesive for fixing the semiconductor elements, the adhesive did not spread along the sides of the concave portions, resulting in prevention of an decrease in adhesiveness of the semiconductor elements to the bottom of the concave portions. In particular, it was discovered that it is effective with a tapered angle of at least 60 degrees but less than 90 degrees.

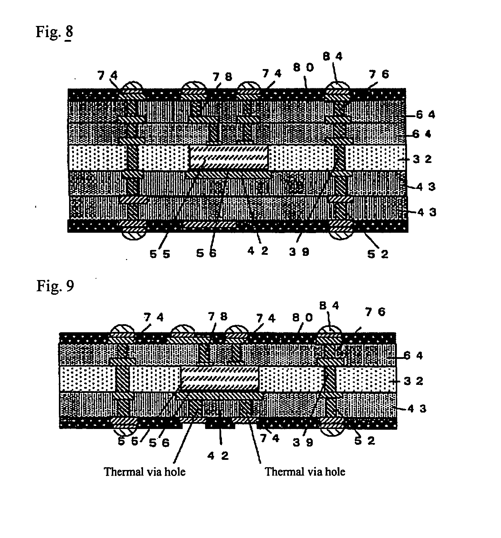

Furthermore, in each Embodiment of the invention, a structure can be provided in which a plurality of layers of conductor circuits and resin-insulating layers is formed on another resin-insulating layer in which semiconductor elements are housed (e.g., as shown in Fig. 8, two other resin-insulating layers are formed on another resin-insulating layer in which semiconductor elements are housed) and via holes for electrical connection between the semiconductor elements and each of the conductor circuit are formed.

Moreover, in each Embodiment of the invention, as shown in Fig. 9, via holes connected to a metal layer can be formed inside a resin-insulating layer to form thermal via holes in which heat generated by the semiconductor elements is released outside the substrate through these via holes.

### Industrial Applicability

As explained above, the multilayer printed circuit board related to the invention has concave portions for housing semiconductor elements formed on the substrate and has a metal layer formed on the bottom of the concave portions, so it can keep the depth of the concave portions equal and reduce inclination of the housed semiconductor elements. Consequently, it can minimize the decrease in adhesiveness of the semiconductor elements to the substrate. Moreover, the metal layer is affected very little by thermal stress, external stress, or the like and reduces warping, so it provides a substrate on which semiconductor elements are attached that reduces the occurrence of poor connections between the connection pad of the semiconductor elements, the conductor circuit of the via holes, and the like, and can endure evaluation tests with severe conditions such as heat cycle tests, and allows very little decrease in electronic connectivity and connection reliability.

## Claims

1. A multilayer printed circuit board, wherein, on a resin-insulating layer that houses a semiconductor element, another resin-insulating layer and a conductor circuit have been formed with electrical connection through a via hole between said semiconductor element and conductor circuit,
wherein said semiconductor element is housed in a concave portion provided on the resin-insulating layer, and a metal layer, on which said semiconductor element is placed, is formed on the bottom of the concave portion.

2. A multilayer printed circuit board, wherein, on a resin-insulating layer that houses a semiconductor element, another resin-insulating layer and conductor circuit have been formed with electrical connection through a via hole between said semiconductor element and conductor circuit,
wherein said semiconductor element is housed in a concave portion provided on the resin-insulating layer, and a metal layer, on which said semiconductor element is placed, is formed on the bottom of the concave portion, and said other resin-insulating layer has a fiber base material.

3. The multilayer printed circuit board according to Claims 1 or 2, wherein a conductor circuit has been formed on a resin-insulating layer that houses the semiconductor element, said conductor circuit being electrically connected with a conductor circuit formed on another resin-insulating layer through a via hole.

4. The multilayer printed circuit board according to Claims 1 or 2, wherein a conductor circuit has been formed on a resin-insulating layer that houses the semiconductor element, said conductor circuit being electrically connected with a conductor circuit formed on another resin-insulating layer through a metal-filled via hole.

5. The multilayer printed circuit board according to Claims 1 or 2, wherein the thickness of the resin-insulating layer that houses the semiconductor element is greater than the thickness of the other resin-insulating layer.

6. The multilayer printed circuit board according to Claims 1 or 2, wherein the conductor circuit on said another resin-insulating layer extends beyond the border between said semiconductor element and said resin-insulating layer that houses said semiconductor element.

7. The multilayer printed circuit board according to Claims 1 or 2, wherein a via hole connected to said metal layer is formed, said via hole being formed as a thermal via hole.

8. A multilayer printed circuit board, wherein, on a resin-insulating layer that houses a semiconductor element, another resin-insulating layer and a conductor circuit have been formed with electrical connection through a via hole between said semiconductor element and conductor circuit,
wherein said semiconductor element is housed in a concave portion provided on the resin-insulating layer, and a metal layer, on which said semiconductor element is placed, is formed on the bottom of the concave portion, and said metal layer is formed on an area that is larger than the area of the bottom of said concave portion.

9. The multilayer printed circuit board according to Claim 8, wherein said metal layer is substantially planarized.

10. The multilayer printed circuit board according to Claim 8, wherein said metal layer is formed from a rolled copper foil.

11. The multilayer printed circuit board according to Claim 8, wherein the wall surface of the concave portion of said resin-insulating layer is exposed.

12. The multilayer printed circuit board according to Claim 8, wherein said metal layer is exposed by laser processing.

13. The multilayer printed circuit board according to Claim 8, wherein the thickness of the portion of the exposed metal layer is less than the thickness of the portion of the unexposed metal layer.

14. The multilayer printed circuit board according to Claim 8, wherein the surface of the portion of exposed metal layer is a shiny surface.

15. The multilayer printed circuit board according to Claim 8, wherein the surface of the back of said metal layer is a matte surface.

16. A multilayer printed circuit board according to Claim 8, wherein said semiconductor element is joined to said metal layer with an adhesive layer there between.

17. The multilayer printed circuit board according to Claim 8, wherein an adhesive layer touches the bottom periphery of the bottom and side of the semiconductor elements.

18. The multilayer printed circuit board according to Claim 8, wherein said metal layer is embedded in a substrate.

19. A multilayer printed circuit board, wherein, on a resin-insulating layer that houses a semiconductor element, another resin-insulating layer and a conductor circuit have been formed with electrical connection through a via hole between said semiconductor element and conductor circuit,
wherein said semiconductor element is housed in a concave portion provided on the resin-insulating layer, and a metal layer, on which said semiconductor element is placed, is formed on the bottom of the concave portion, and the wall surface of said concave portion is exposed.

20. The multilayer printed circuit board according to Claim 19, wherein the space between the wall surface of the concave portion and the side of the semiconductor elements is filled with a resin layer.

21. The multilayer printed circuit board according to Claim 19, wherein the space defined by the wall surface of the concave portion and the side of the semiconductor elements is filled with a resin-insulating layer, and said resin-insulating layer is integrated with the semiconductor element.

22. The multilayer printed circuit board according to Claim 19, wherein a side of said concave portion is tapered so as to become broader from the bottom upward.

23. The multilayer printed circuit board according to Claim 19, wherein said tapered shape has an angle of at least 60 degrees but less than 90 degrees.

24. A multilayer printed circuit board, wherein, on a resin-insulating layer that houses a semiconductor element, another resin-insulating layer and a conductor circuit have been formed with electrical connection through a via hole between said semiconductor element and conductor circuit,
wherein said semiconductor element is housed in a concave portion provided on the resin-insulating layer, and a metal layer, on which said semiconductor element is placed, is formed on the bottom of the concave portion, and an opening that forms said via hole is filled with a conductive material.

25. The multilayer printed circuit board according to Claim 24, wherein a cross-section of said via hole is drum shaped.

26. The multilayer printed circuit board according to Claim 24, wherein said solder pad is placed above said semiconductor element.

27. The multilayer printed circuit board according to Claim 24, wherein one or more layers of resin-insulating layer is laminated on said another resin-insulating layer, and a via hole to be connected to the conductor circuit is formed.

28. The multilayer printed circuit board according to Claim 24, wherein a columnar electrode or a mediation layer is formed on a pad of the semiconductor elements, and the pad and the via hole are electrically connected through the columnar electrode or the mediation layer.

29. A multilayer printed circuit board, wherein, on a resin-insulating layer that houses a semiconductor element, another resin-insulating layer and conductor circuit have been formed with an electrical connection through a via hole between said semiconductor element and conductor circuit,
wherein the side of said concave portion is tapered so as to become broader from the bottom upward.

30. The multilayer printed circuit board according to Claim 29, wherein said tapered shape has an angle of at least 60 degrees but less than 90 degrees.

31. The multilayer printed circuit board according to Claim 29, wherein the wall surface of the concave portion is exposed.

32. The multilayer printed circuit board according to Claim 29, wherein the space between the wall surface of the concave portion and the side of the semiconductor elements is filled with a resin layer.

33. The multilayer printed circuit board according to Claim 29, wherein the space between the wall surface of the concave portion and the side of the semiconductor elements is filled with a resin-insulating layer, and said resin-insulating layer is integrated with the semiconductor element.

34. A method of manufacturing a multilayer printed circuit board, wherein, on a resin-insulating layer on which a semiconductor element is housed and fixed, another resin-insulating layer and a conductor circuit are formed with an electrical connection though a via hole between said semiconductor element and conductor circuit, said method comprising at least the steps of:
forming a first insulating resin base material, by forming, on one surface of the resin-insulating layer, at least a conductor circuit and a metal layer with a predetermined area relative to the size of the semiconductor element to be housed, and forming, on the other surface, at least a conductor circuit and a conductor circuit non-formation area facing said metal layer with a predetermined area relative to the size of the semiconductor element, and then forming a via hole for electrically connecting the conductor circuit on one surface and the conductor circuit on the other surface;
unifying by crimping a second insulating resin base material on which a copper foil is attached on one surface of the resin-insulating layer with said one surface of said first insulating resin base material;
forming a conductor circuit on one surface of said second insulating resin base material and forming a via hole to electrically connect said conductor circuit to the conductor circuit formed on said one surface of said first insulating resin base material;
forming, on the conductor circuit non-formation area of said first insulating resin base material, a concave portion extending from a resin-insulating layer surface to the metal layer to expose the surface of the metal layer,
housing a semiconductor element within said concave portion and adhering and fixing it to the surface of the metal layer exposed within said concave portion using an adhesive;
coating said semiconductor element and forming another resin-insulating layer and a conductor circuit, and then forming a via hole to electrically connect one surface of said second insulating resin base material and forming a via hole to electrically connect said semiconductor element and said conductor circuit.

35. The method of manufacturing a multilayer printed circuit board according to Claim 34,
wherein said concave portion is formed by laser radiation to have a tapered side so as to become broader from the bottom upward.

36. The method of manufacturing a multilayer printed circuit board according to Claim 34,
wherein a columnar electrode or a mediation layer has been formed in advance on a pad of the semiconductor elements, and the pad and the via hole are electrically connected through the columnar electrode or the mediation layer.
